# EUROPEAN PATENT APPLICATION

(11) **EP 2 495 756 A2**
(43) Date of publication of application: **05.09.2012**
(21) Application number: 11187603.3
(22) Date of filing: 03.11.2011
(51) Int. Cl.: H01L 21/28, H01L 29/792, H01L 29/423, H01L 29/66

(54) **Non-volatile memory structure and method for manufacturing the same**

(30) Priority: 03.03.2011 US 449074 P
(71) Applicant: eMemory Technology Inc., Hsin-Chu 30075 (TW)
(72) Inventor: Lu, Hau-Yan, 300 Hsinchu City (TW); Chen, Hsin-Ming, 300 Hsinchu City (TW); Yang, Ching-Sung, 300 Hsinchu City (TW)
(74) Representative: Becker Kurig Straus

(57) **Abstract**

A non-volatile memory structure (50, 60) is disclosed. LDD regions (72, 73) may be optionally formed through an ion implantation using a mask (61, 71) for protection of a gate channel region of an active area (56, 66). Two gates (52, 62, 53, 63) are apart from each other and disposed on an isolation structure (54) on two sides of a middle region of the active area (56, 66), respectively. The two gates (52, 62, 53, 63) may be each entirely disposed on the isolation structure (54) or partially to overlap a side portion of the middle region of the active area (56, 66). A charge-trapping layer (58) and a dielectric layer (69) are formed between the two gates (52, 62, 53, 63) and on the active area (56, 66) to serve as a storage node function. They may be further formed onto all sidewalls of the two gates (52, 62, 53, 63) to serve as spacers. Source/drain regions (78, 79) are formed through ion implantation using a mask (76, 82) for protection of the gates (52, 62, 53, 63) and the charge-trapping layer (58).

## Description

### Field of the Invention

The present invention relates to a semiconductor structure and process, and particularly to a memory structure and method for manufacturing the same according to the pre-characterizing clauses of claims 1 and 9.

### Background of the Invention

Non-volatile memory (NVM) is a type of memory that retains information even when no power is supplied to memory blocks. Some examples include magnetic devices, optical discs, flash memory, and other semiconductor-based memory technologies. As semiconductor memory techniques have matured, one advantage that has come out is the ability to integrate substantial amounts of memory cells in integrated circuits (ICs). However, it is desirable that the memory cells be formed in the same process with the ICs.

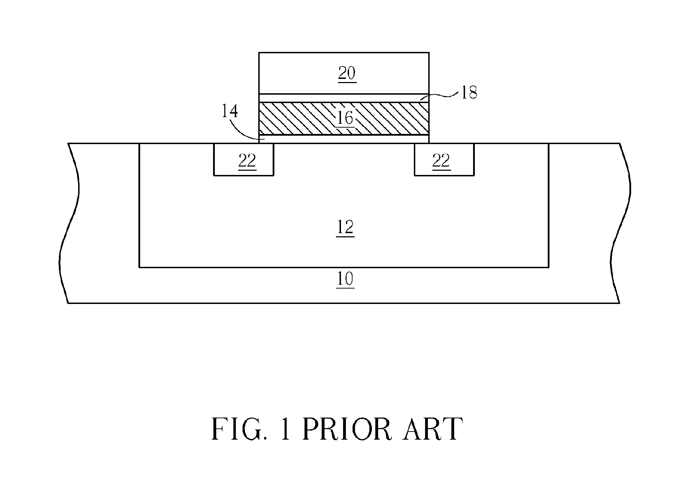

Referring to the Fig. 1, a conventional NVM cell includes a substrate 10, a P-well 12 positioned in the substrate 10, a stacked structure, which is composed of an insulating layer 14, a floating gate 16, an insulating layer 18 and a control gate 20, positioned on the P-well 12, and an N-type doping region 22 positioned in the P-well 12 to surround the stacked structure. The floating gate 16 and the control gate 20 are normally formed of doped polysilicon. The insulating layer 14 positioned beneath the floating gate 16 functions as a tunneling oxide layer. The insulating layer 18 positioned between the floating gate 16 and the control gate 20 is an ONO composite layer. In addition, the N-type doping region 22 surrounding the floating gate 16 functions as a drain and a source to control the programming, erasing or reading operations of the NVM cell. As compared with a conventional CMOS manufacturing process, the formation of the stacked structure needs extra steps for depositing the floating gate 16 and the insulating layer 18.

Many various topologies have been provided for forming memory cells with charge storage layers. However, the fabrication of the memory cells is tedious. Therefore, there is still a need for a novel memory structure to be fabricated easily.

### Summary of the Invention

This in mind, the present invention aims at providing an easily fabricated, non-volatile memory structure that has good electric properties.

This is achieved by a non-volatile memory structure according to claims 1 and 9. The dependent claims pertain to corresponding further developments and improvements.

As will be seen more clearly from the detailed description following below, the claimed non-volatile memory structure includes a dielectric layer and a charge trapping layer that disposed between the two gates for serving in a storage node function.

A method for manufacturing a non-volatile memory structure according to an embodiment of the present invention includes the following steps. A substrate is provided. The substrate includes an active area and an isolation structure surrounding the active area. The active area includes a pair of predetermined source/drain regions and a middle region therebetween. A first gate and a second gate are formed on the substrate and are opposite each other, such that at least one portion of the middle region of the active area is between the first gate and the second gate. A dielectric layer is conformally formed on the substrate. A charge-trapping layer is conformally formed on the dielectric layer.

The dielectric layer and the charge-trapping layer are partially etched using a first mask to retain a portion of the dielectric layer and a portion of the charge-trapping layer on the substrate between the first gate and the second gate and on two opposite sidewalls of the first gate and the second gate to serve for a storage node function. A first dopant is implanted into the pair of predetermined source/drain regions of the active area to form a pair of source/drain regions through a second mask covering the middle region of the active area, the first and the second gates and the charge storage node.

A non-volatile memory structure according to another embodiment of the present invention includes a substrate, a first gate, a second gate, a dielectric layer, and a charge-trapping layer. The substrate includes an active area and an isolation structure surrounding the active area. The active area includes a pair of source/drain regions and a middle region between the two source/drain regions. The first gate and the second gate are disposed entirely on the isolation structure and opposite each other, such that the middle region of the active area is between the first and the second gates. The dielectric layer is disposed on the substrate between the first gate and the second gate and on two opposite sidewalls of the first gate and the second gate. The charge-trapping layer is disposed on the dielectric layer between the first gate and the second gate and between the source region and the drain region and with the dielectric layer together to serve for a storage node function.

In the non-volatile memory structure, the fabrication process is compatible with a CMOS manufacturing process. In addition, the charge-trapping layer is disposed between the two gates for serving in a storage node function, and the charge-trapping layer may be further formed on whole sidewalls of the gates to serve as spacers; accordingly, the fabrication can be convenient.

### Brief Description of the Drawings

In the following, the invention is further illustrated by way of example, taking reference to the accompanying drawings. Thereof
FIG 1 is a schematic cross-sectional view illustrating a conventional non-volatile memory structure;
FIG 2 is a schematic plan view illustrating a non-volatile memory structure according to an embodiment of the present invention;
FIG 3 is a schematic plan view illustrating a non-volatile memory structure manufactured using a method according to an embodiment of the present invention;
FIGS. 4 to 11 are schematic cross-sectional views illustrating a method for manufacturing a non-volatile memory structure as shown in FIG 2 according to an embodiment of the present invention; and
FIGS. 12 to 17 are schematic cross-sectional views illustrating a method for manufacturing a non-volatile memory structure as shown in FIG 3 according to another embodiment of the present invention.

### Detailed Description

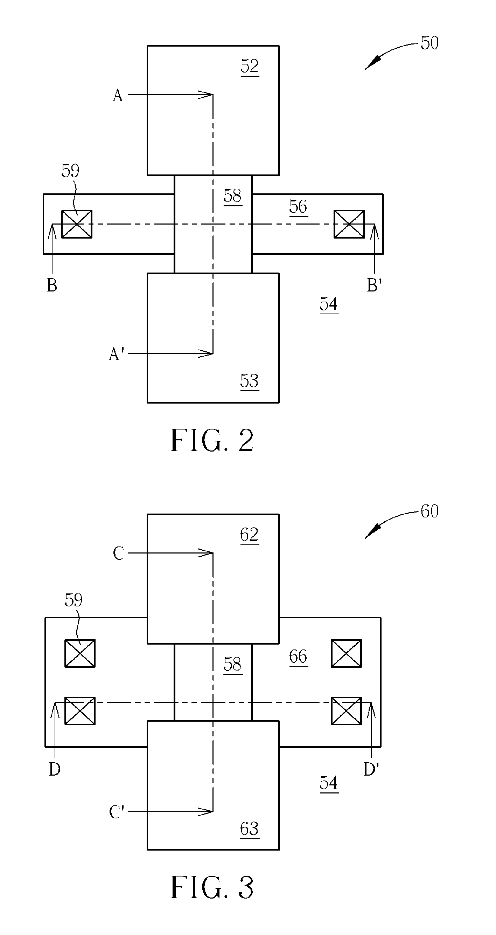

Referring to FIG 2, in a non-volatile memory structure 50 according to the present invention, a first gate 52 and a second gate 53 are each entirely disposed on an isolation structure 54 and opposite each other. The isolation structure 54 surrounds an active area 56, both disposed within a substrate (not shown). The active area 56 has a portion (a middle region) between the first gate 52 and the second gate 53. A dielectric layer (not shown) is disposed on a sidewall of each of the first gate 52 and the second gate 53 and on the substrate between the first gate 52 and the second gate 53. The dielectric layer may be for example a liner dielectric, such as a liner oxide. A charge-trapping layer 58 is disposed on the dielectric layer, such that the charge-trapping layer 58 is also between the first gate 52 and the second gate 53. The charge-trapping layer 58 and the dielectric layer together serve for a storage node function. A pair of source/drain regions (not shown) are formed within the active region beside the charge-trapping layer 58. More specifically, the middle region of the active area is between the source region and the drain region. A contact 59 is formed on each of the source/drain regions.

FIG 3 illustrates an alternative embodiment, a non-volatile memory structure 60, which mainly differs from the non-volatile memory structure 50 in gate locations. The first gate 62 and the second gate 63 are also opposite each other; while each partially overlaps a portion of the middle region of the active area 66.

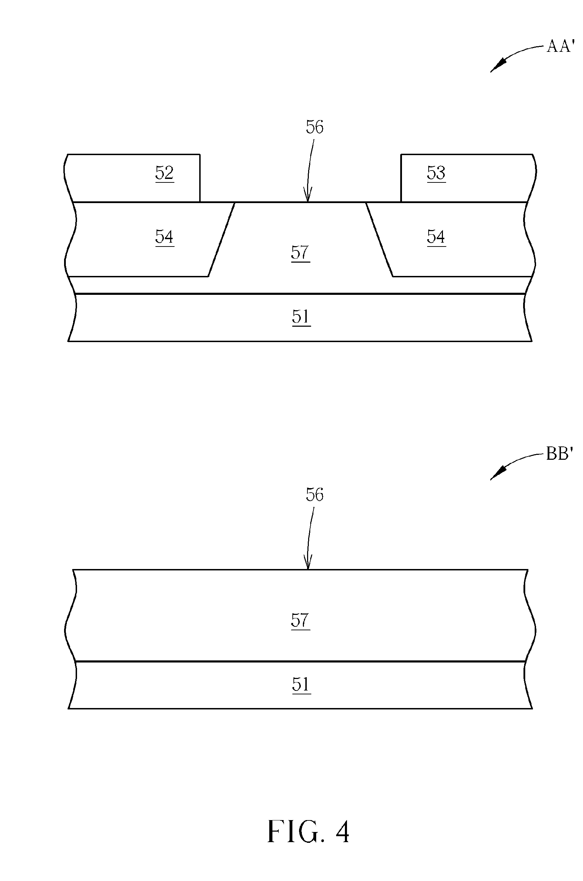

Referring to FIGS. 4-11 each showing cross-sectional views along line AA' and line BB' as shown in FIG 2, a method for manufacturing a non-volatile memory structure according to an embodiment of the present invention is described as follows. First, referring to FIG 4, a substrate 51 is provided. The substrate 51 may be a semiconductor substrate, such as a silicon substrate or a silicon-on-insulator (SOI) substrate. An isolation structure 54, such as shallow trench isolation (STI), is formed to surround an active area 56 within the substrate 51. A well 57, such as p type well or n type well may be formed within the active area 56 through an ion implantation process. The active area 56 may include a middle region and a pair of predetermined source/drain regions beside the middle region. A first gate 52 and a second gate 53 are formed opposite each other on the substrate. In other words, the first gate 52 and the second gate 53 are allowed to be apart from each other and each entirely on the isolation structure 54, not contacting (or touching) the active area 56. Accordingly, an entire middle region of the active area 56 is exposed from the gap between the two gates 52 and 53. The gates may include poly silicon or metal gate.

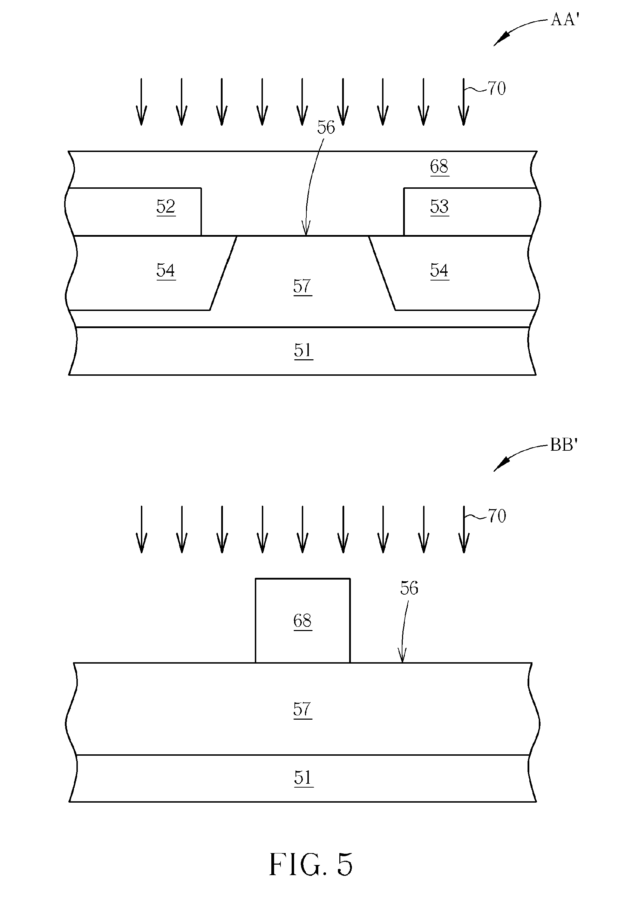

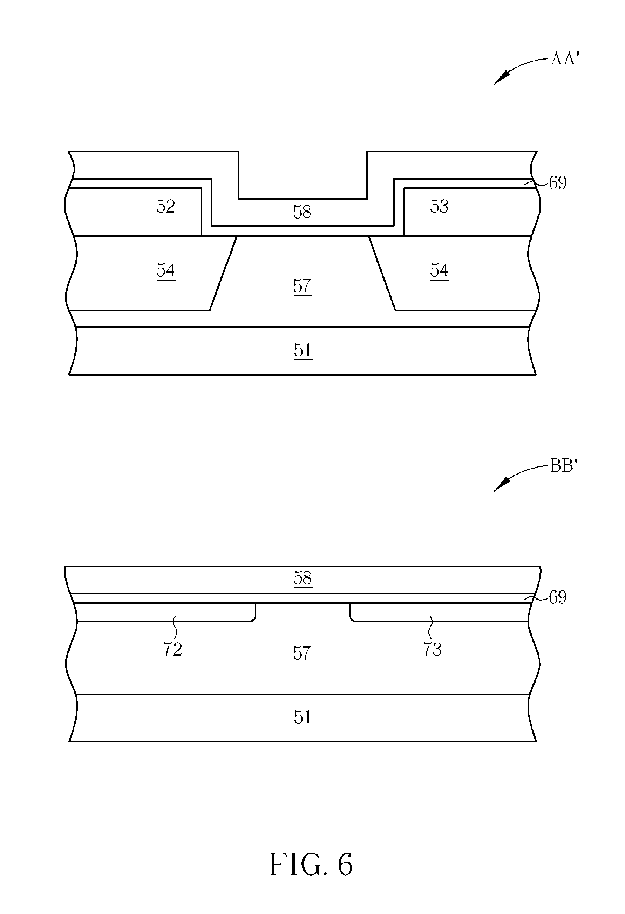

Next, optionally, a dopant is implanted into the active area 56 to form a pair of LDD regions, which may be accomplished through, for example, as shown in FIG 5, forming a mask 68 on the substrate 51 to block LDD implant for forming a non-doped region in the storage node in an ion implantation process 70. The middle region of the active area 56 between the first and the second gates 52 and 53 is protected by the mask 68 from being doped. Accordingly, a pair of LDD regions 72 and 73 is formed, as shown in FIG 6. The mask 68 may be for example a patterned photo resist layer formed by a lithography and etching process. The dopant (the LDD implant) may be for example in a light concentration.

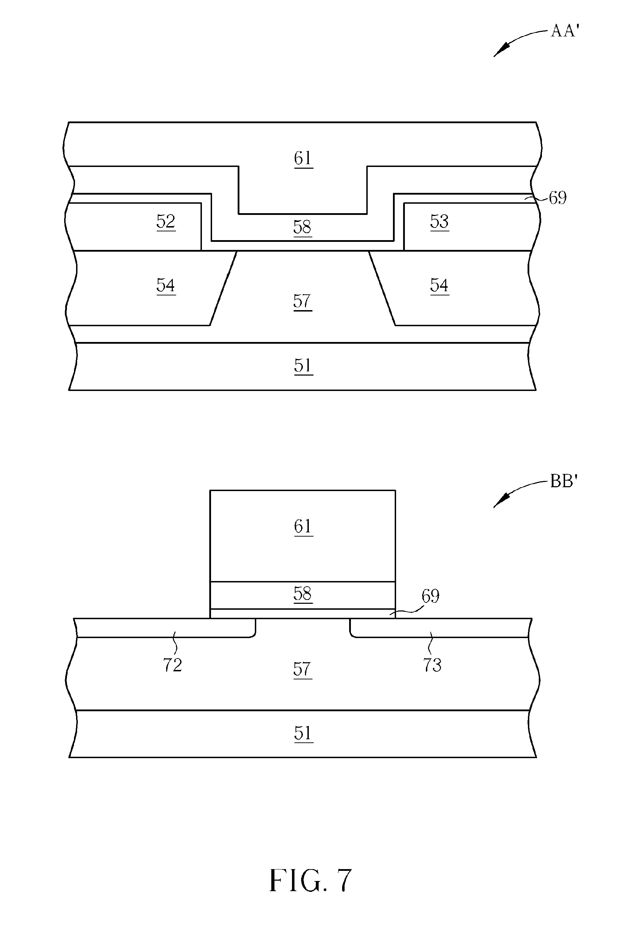

Thereafter, referring to FIG 6, a dielectric layer 69, such as an oxide layer, is conformally formed on the substrate. The dielectric layer 69 may be formed using conventional processes used in a CMOS fabrication, such as thermal oxidation or in-situ steam generation process. Thereafter, a charge-trapping layer 58 is conformally formed on the dielectric layer 69. The charge-trapping layer 58 may include a charge-trapping dielectric material, such as a spacer material that has charge trapping properties, e.g. silicon nitride or a high-k dielectric, and it may be a singular layer or a multi-layer (such as an ONO composite layer) and may be formed through a chemical vapor deposition process. Thereafter, referring to FIG 7, they may be patterned through an etching process using a mask 61, such as a patterned photo resist layer, to remove undesired portions, such that the remaining charge-trapping layer 58 may be on the remaining dielectric layer 69 positioned on the active area 56 of the substrate and on two opposite sidewalls of the two gates 52 and 53. Through the etching process, another portion of the dielectric layer 69 and another portion of the charge-trapping layer 58 may optionally further remain on other sidewalls of the two gates 52 and 53 to serve as spacers. The spacers may be otherwise formed using conventional technique as desired; however, it is convenient to form the charge storage node and the spacers in one process.

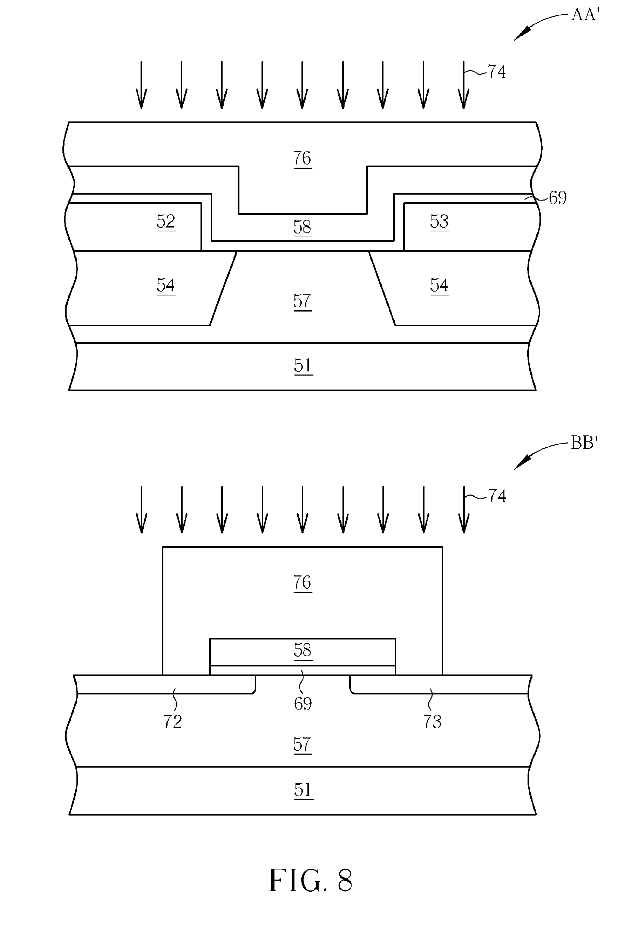

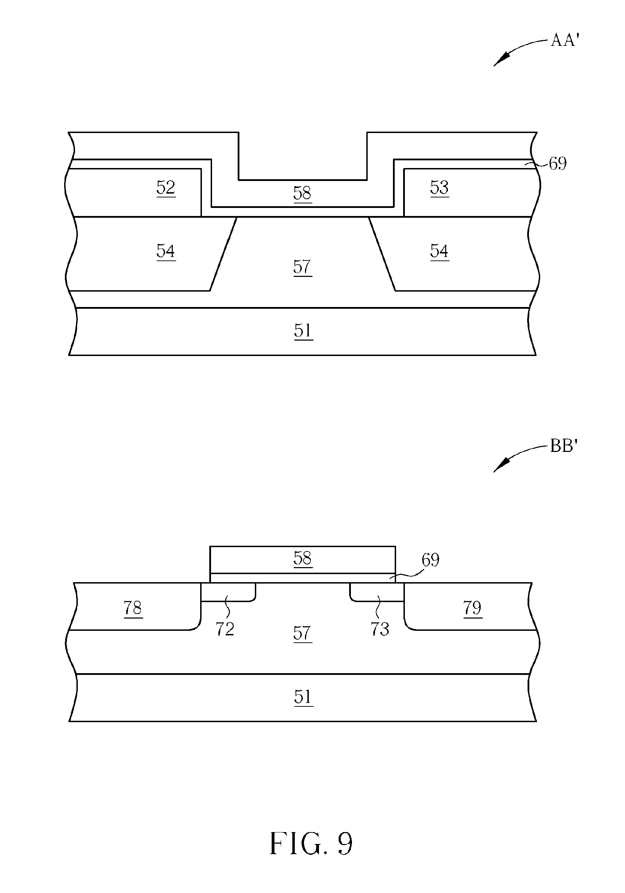

The mask 61 is removed. Thereafter, referring to FIG 8, an ion implantation 74 is performed to implant a dopant with a relatively heavy concentration into the pair of predetermined source/drain regions of the active area using a mask 76, such as patterned photo resist layer, protecting the middle region of the active area 56 and the two gates 52 and 53 and the charge-trapping layer 58 thereon from being implanted with the dopant, to form a channel region defined by a pair of source/drain regions 78 and 79, as shown in FIG 9. Thereafter, the mask 76 is removed.

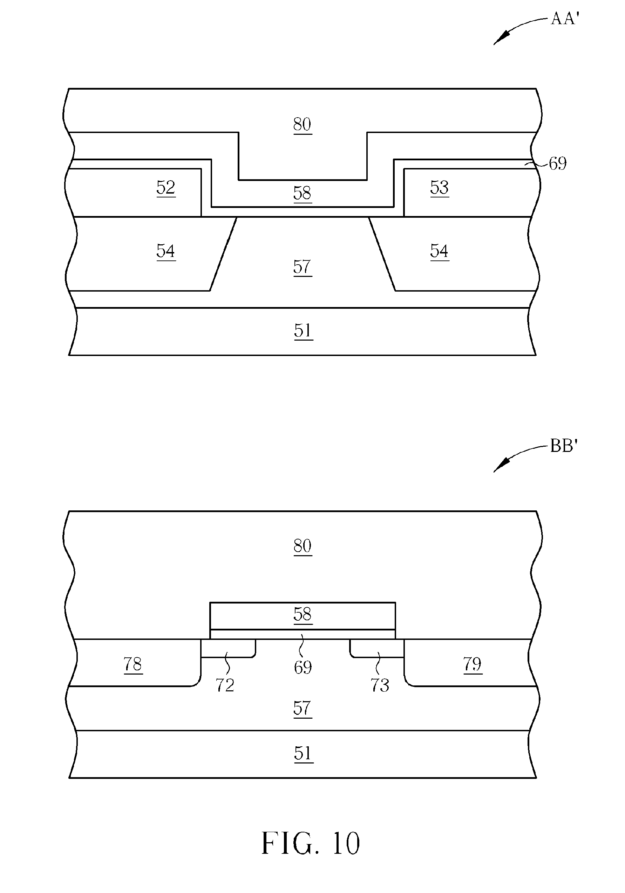

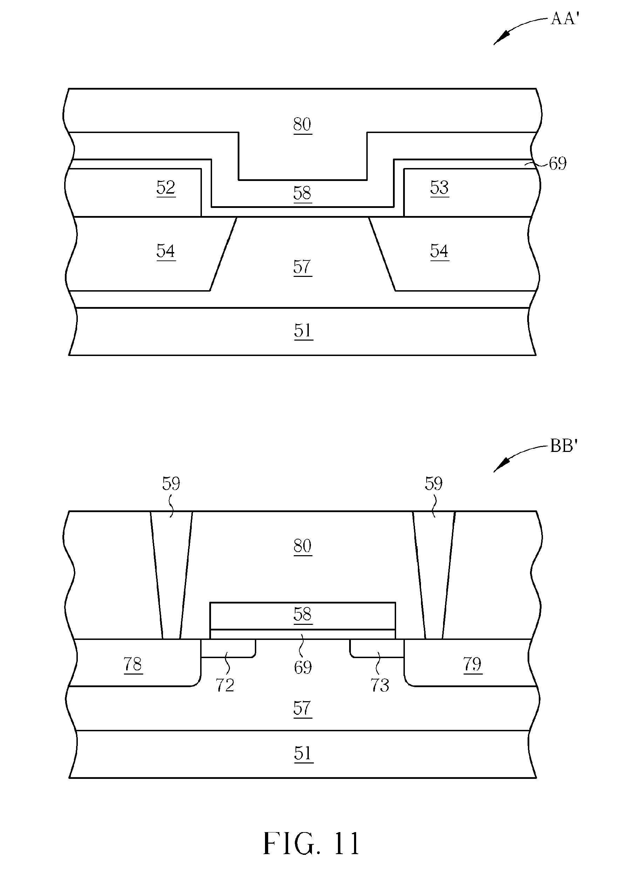

Referring to FIG 10, a contact etch stop layer (CESL) 80 may be further formed over the substrate 51 to cover the charge-trapping layer 58 and the gate and the active area 56. It may be formed using a conventional process. Thereafter, referring to FIG 11, contacts 59 may be further formed through the CESL 80 to contact the source/drain regions 78 and 79, respectively.

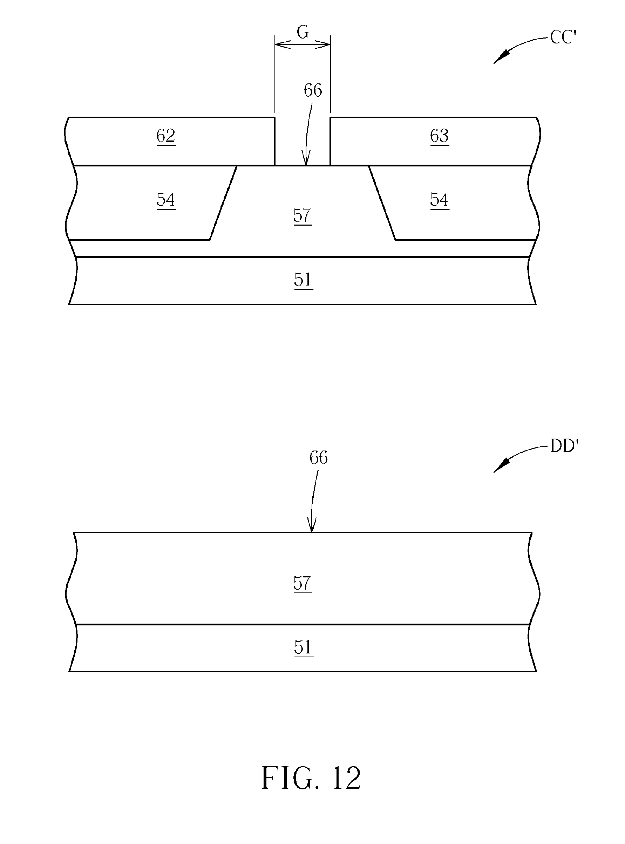

FIG 12 to FIG 17, each of which showing a cross-sectional view along line CC' and line DD' as shown in FIG. 3, illustrate a method for manufacturing a non-volatile memory structure according to another embodiment of the present invention. In this embodiment, the first gate 62 and the second gate 63 each partially overlap a side portion of the middle region of the active area 66, and such feature can be clearly shown by the schematic cross-sectional views of FIGS. 12-17. Accordingly, the method for manufacturing the non-volatile memory structure 60 as shown in FIG 3 is similar to that for manufacturing the non-volatile memory structure 50 as shown in FIG. 2, except that the first gate 62 and the second gate 63 are made so that each to partially overlaps a side portion of the middle region of the active area 66.

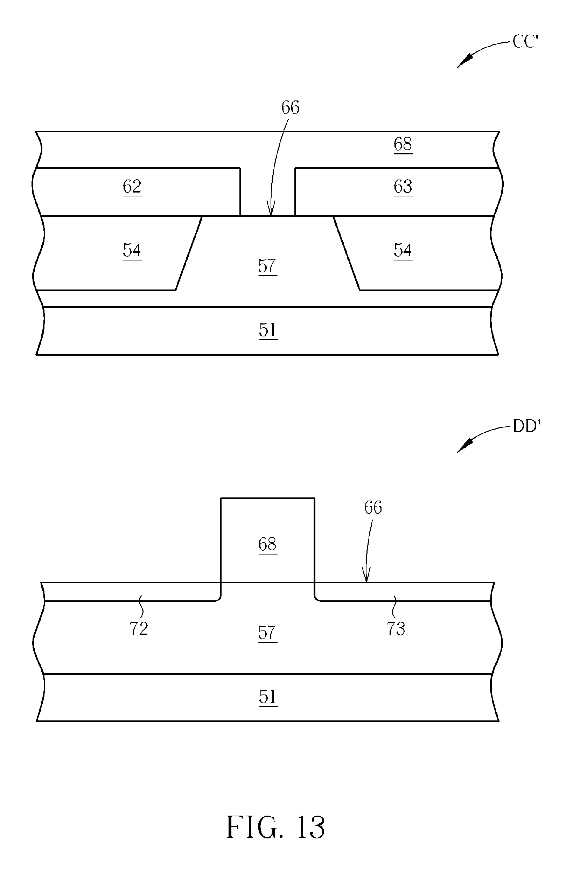

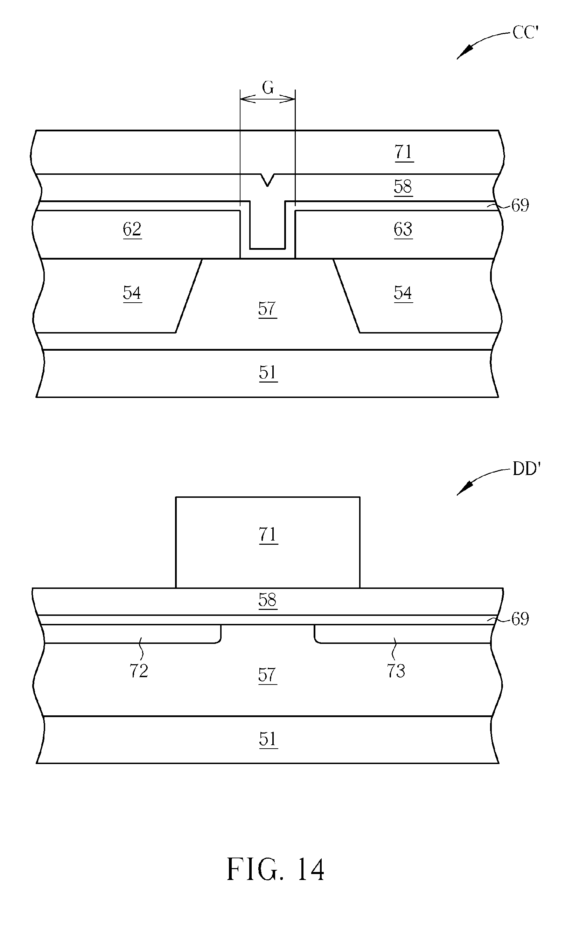

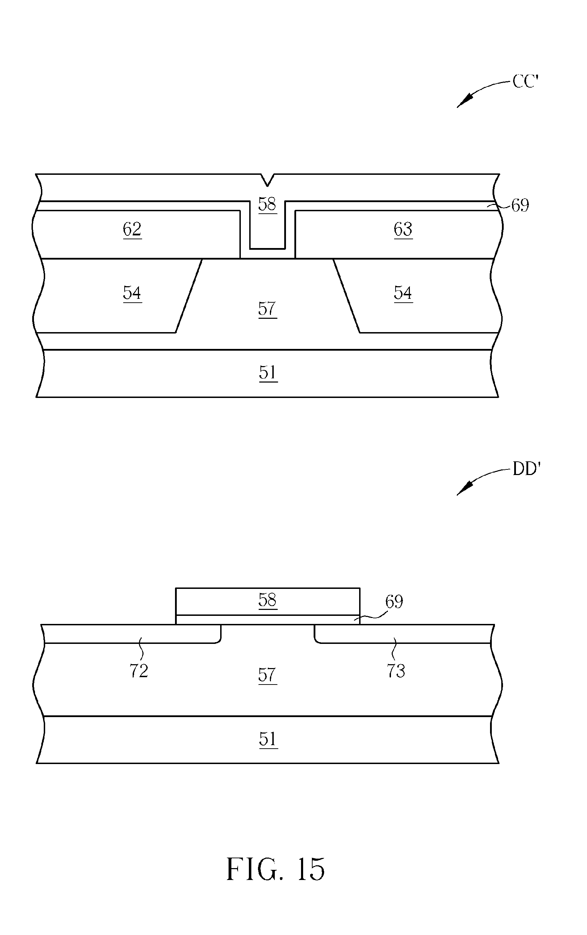

First, referring to FIG 12, similar to the aforesaid, a substrate 51 is provided. The substrate 51 includes an isolation structure 54 surrounding an active area 66. A well 57 may be further formed within the active area 66. A first gate 62 and a second gate 63 are formed opposite each other and beside the middle region of the active area 66. The first gate 62 and the second gate 63 each partially overlap the middle region of the active area 66, forming a gap G between the first gate 62 and the second gate 63. Thereafter, referring to FIG. 13, a pair of LDD regions 72 and 73 is optionally formed by implanting a dopant into the active area 66 using a mask 68, such as a patterned photo resist layer, to protect the middle region of the active area 66 and the gates 62, 63. The mask 68 is removed. Thereafter, referring to FIG 14, a dielectric layer 69, such as an oxide layer, and a charge-trapping layer 58 are formed, and a mask 71, such as a patterned photo resist layer, is formed for patterning the underlying charge-trapping layer 58 and the dielectric layer 69 by for example etching. As the gap G may be relatively narrow, the portion of the charge-trapping layer 58 within the gap G may be relatively thick. The patterned charge-trapping layer 58 and the patterned dielectric layer 69 are as shown in FIG 15.

At least, after the etching process, a portion of the charge-trapping layer 58 and a portion of the dielectric layer 69 remain on the middle region of the active area 66 and the opposite sidewalls of the first and the second gates 62 and 63 within the gap G to serve for a storage node function. Other portions of the dielectric layer 69 and the charge-trapping layer 58 may further remain on other sidewalls of the gates 62 and 63, to serve as spacers. The tops of the first and the second gates 62 and 63 may be also covered with the dielectric layer 69 and the charge-trapping layer 58.

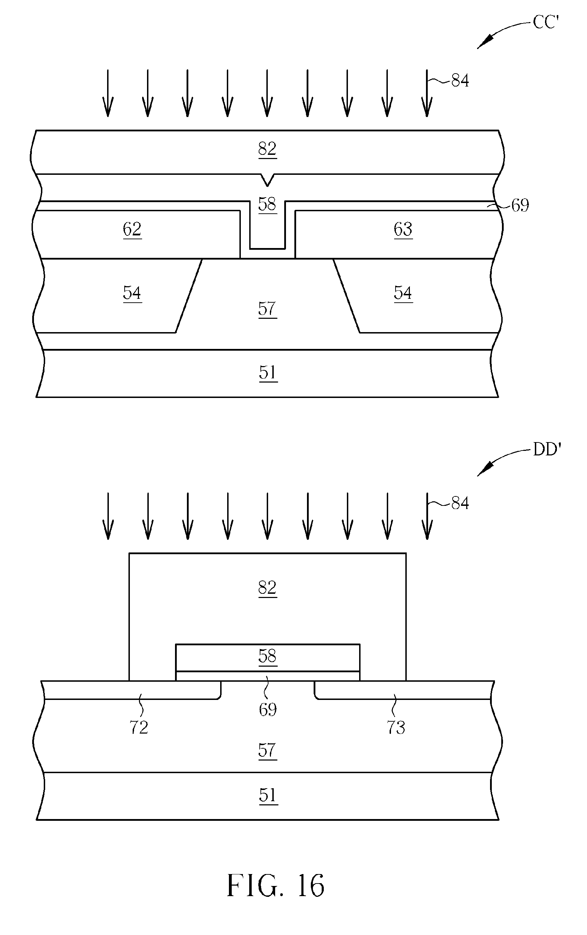

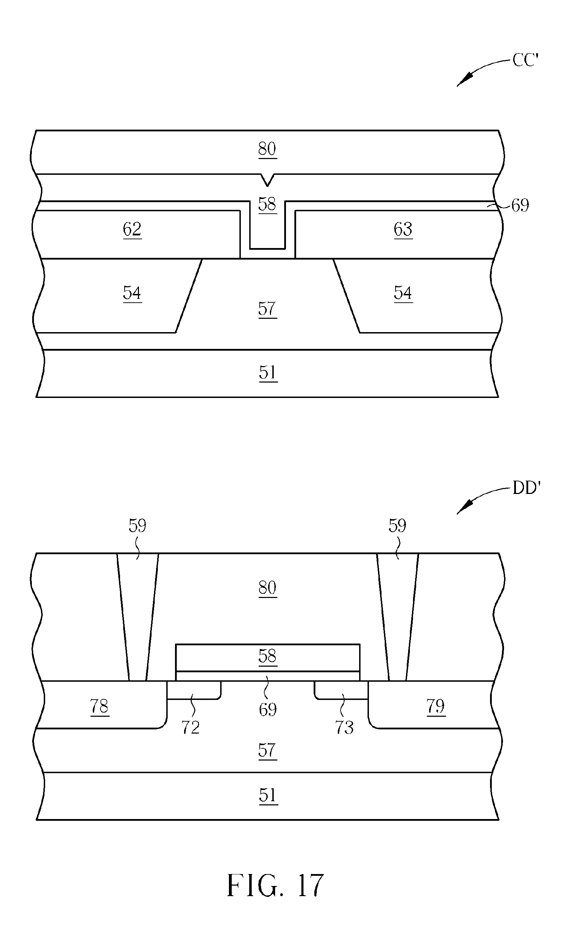

Thereafter, referring to FIG 16, an ion implantation 84 is performed to implant a dopant with a relatively heavy concentration into the pair of predetermined source/drain regions of the active area using a mask 82, such as patterned photo resist layer, to protect a portion of the middle region of the active area 66 and the gates 62 and 63 and the charge-trapping layer 58 thereon from being implanted with the dopant to form a pair of source/drain regions 78 and 79, as shown in FIG 17. After the mask 82 is removed, referring to FIG 17, a CESL 80 may be further formed and contacts 59 may be further formed through the CESL 80 to contact with the source/drain regions 78 and 79, respectively.

For the aforesaid description, like numerals designate similar or the same parts, regions or elements in the drawings. It is to be understood that the drawings are not drawn to scale and are served only for illustration purposes. For the electric properties of each component, when the source/drain regions are n type, the LDD regions are n type and the well is p type, and when the source/drain regions are p type, the LDD regions are p type and the well is n type. The distance between the two gates, the distance between the gate and the active area and the sizes of the active area, gates and other components may be designed as required, but will be limited to the critical dimension in the manufacturing process.

For the novel non-volatile memory structure according to the present invention, the charge storage node in the non-volatile memory structure according to the present invention can be programmed by applying a voltage of, for example, 5 volts, to the two gates and the drain, and grounding the source. Thus, channel hot electrons from the source region may enter the charge storage node by traveling through channel region within the middle region of the active area under the liner dielectric. To erase the charge storage node, a voltage of, for example, -5 volts and 5 volts may be applied to the two gates and the drain, respectively, so that band to band induced hot holes at the drain may inject into the storage node to combine the trapped electrons.

It is to be noted that when the non-volatile memory structure is utilized for array application, a select transistor is added beside the non-volatile memory structure to form a memory cell. The process of the select transistor is usually compatible with standard CMOS process, but is not limited thereto.

For completeness, further various aspects of the invention are further set out in the following numbered clauses:
Clause 1: A method for manufacturing a non-volatile memory structure, comprising:
   providing a substrate comprising an active area and an isolation structure surrounding the active area, wherein the active area comprises a pair of predetermined source/drain regions and a middle region therebetween;
   forming a first gate and a second gate on the substrate and opposite each other, such that at least one portion of the middle region of the active area is between the first gate and the second gate;
   forming a dielectric layer conformally on the substrate;
   forming a charge-trapping layer conformally on the dielectric layer;
   partially etching the dielectric layer and the charge-trapping layer using a first mask to remain a portion of the dielectric layer and a portion of the charge-trapping layer on the substrate between the first gate and the second gate and on two opposite sidewalls of the first gate and the second gate to serve for a storage node function; and
   implanting a first dopant into the pair of predetermined source/drain regions of the active area to form a pair of source/drain regions through a second mask covering the middle region of the active area, the first and the second gates and
   the portion of the charge-trapping layer.
Clause 2: The method for manufacturing a non-volatile memory structure according to clause 1, further, before forming the dielectric layer, comprising:
   implanting a second dopant into the active area to form a pair of LDD regions through a third mask covering the middle region of the active area.
Clause 3: The method for manufacturing a non-volatile memory structure according to clause 2, wherein the third mask comprises a photo resist layer.
Clause 4: The method for manufacturing a non-volatile memory structure according to clause 1, wherein the first mask comprises a photo resist layer.
Clause 5: The method for manufacturing a non-volatile memory structure according to clause 1, wherein the second mask comprises a photo resist layer.

## Claims

1. A method for manufacturing a non-volatile memory structure (50, 60) **characterized by**:
providing a substrate (51) comprising an active area (56, 66) and an isolation structure (54) surrounding the active area (56, 66), wherein the active area (56, 66) comprises a pair of predetermined source/drain regions (78, 79) and a middle region therebetween;
forming a first gate (52, 62) and a second gate (53, 63) on the substrate (51) and opposite each other, such that at least one portion of the middle region of the active area (56, 66) is between the first gate (52, 62) and the second gate (53, 63);
forming a dielectric layer (69) conformally on the substrate (51);
forming a charge-trapping layer (58) conformally on the dielectric layer (69); partially etching the dielectric layer (69) and the charge-trapping layer (58) using a first mask (61, 71) to remain a portion of the dielectric layer (69) and a portion of the charge-trapping layer (58) on the substrate (51) between the first gate (52, 62) and the second gate (53, 63) and on two opposite sidewalls of the first gate (52, 62) and the second gate (53, 63) to serve for a storage node function; and
implanting a first dopant (74, 84) into the pair of predetermined source/drain regions (78.79) of the active area (56, 66) to form a pair of source/drain regions (78, 79) through a second mask (76, 82) covering the middle region of the active area (56, 66), the first (52, 62) and the second gates (53, 63) and the portion of the charge-trapping layer (58).

2. The method for manufacturing a non-volatile memory structure (50, 60) according to claim 1, further **characterized by** forming each of the first gate (52) and the second gate (53) to be entirely on the isolation structure (54) and not to contact the active area (56, 66).

3. The method for manufacturing a non-volatile memory structure (50, 60) according to claim 1, further **characterized by** forming each of the first gate (62) and the second gate (63) to be partially on the isolation structure (54) and partially overlap a side portion of the middle region of the active area (56, 66).

4. The method for manufacturing a non-volatile memory structure (50, 60) according to claim 1, further **characterized by** before forming the dielectric layer (69), implanting a second dopant into the active area (56, 66) to form a pair of LDD
regions (72, 73) through a third mask (68) covering the middle region of the active area (56, 66).

5. The method for manufacturing a non-volatile memory structure (50, 60) according to claim 1, further **characterized by** implanting a third dopant into the substrate (51) in the active area (56, 66) to form a well (57).

6. The method for manufacturing a non-volatile memory structure (50, 60) according to claim 1, further **characterized by** forming a contact etch stop layer (80) over the substrate (51).

7. The method for manufacturing a non-volatile memory structure (50, 60) according to claim 6, further **characterized by** forming two contacts (59) through the contact etch stop layer (80) and on the source/drain regions (78, 79) correspondingly.

8. The method for manufacturing a non-volatile memory structure (50, 60) according to claim 1, further **characterized by** etching the dielectric layer (69) and the charge-trapping layer (58) through the first mask (61, 71) to remain on sidewalls of the first gate (52, 62) and the second gate (53, 63) to serve as spacers.

9. A non-volatile memory structure (50, 60), **characterized by**:
a substrate (51) including an active area (56, 66) and an isolation structure (54) surrounding the active area (56, 66), wherein the active area (56, 66) comprises a pair of source/drain regions (78, 79) and a middle region between the two source/drain regions (78, 79);
a first gate (52, 62) and a second gate (53, 63) disposed entirely on the isolation structure (54) and opposite each other with the middle region of the active area (56, 66) therebetween;
a dielectric layer (69) disposed on the substrate (51) between the first gate (52, 62) and the second gate (53, 63) and on two opposite sidewalls of the first gate (52, 62) and the second gate (53, 63); and
a charge-trapping layer (58) disposed on the dielectric layer (69) between the first gate (52, 62) and the second gate (53, 63) and between the source region (78) and the drain region (79) and with the dielectric layer (69) together to serve for a storage node function.

10. The non-volatile memory structure (50, 60) according to claim 9, further **characterized by** a pair of LDD regions (72, 73), one of the pair of LDD regions being between the dielectric layer (69) and each of the source/drain regions (78, 79) respectively.

11. The non-volatile memory structure (50, 60) according to claim 9, further **characterized by** a contact etch stop layer (80) covering the charge-trapping layer (58) and the source/drain regions (78, 79).

12. The non-volatile memory structure (50, 60) according to claim 11, further **characterized by** two contacts (59) disposed through the contact etch stop layer (80) and on the source/drain regions (78, 79) correspondingly.

13. The non-volatile memory structure (50, 60) according to claim 9, further **characterized in that** the active area (56, 66) comprises a well (57) of a dopant.

14. The non-volatile memory structure (50, 60) according to claim 9, further **characterized in that** the charge-trapping layer (58) is formed as a conformal layer.

15. The non-volatile memory structure (50, 60) according to claim 9, further **characterized in that** the charge-trapping layer (58) comprises silicon nitride.

16. The non-volatile memory structure (50, 60) according to claim 9, further **characterized in that** the dielectric layer (69) and the charge-trapping layer (58) are further disposed on the tops and sidewalls of the first gate (52, 62) and the second gate (53, 63) to serve as spacers.
